(19) Europäisches Patentamt
European Patent Office
Office européen des brevets

(11) EP 2 450 973 A1

(12) EUROPEAN PATENT APPLICATION
published in accordance with Art. 153(4) EPC

(43) Date of publication:
09.05.2012 Bulletin 2012/19

(51) Int Cl.:
H01L 33/62 (2010.01)      H01L 33/64 (2010.01)

(21) Application number: 10794246.8

(22) Date of filing: 02.07.2010

(86) International application number:
PCT/JP2010/061317

(87) International publication number:
WO 2011/002078 (06.01.2011 Gazette 2011/01)

(84) Designated Contracting States:
AL AT BE BG CH CY CZ DE DK EE ES FI FR GB
GR HR HU IE IS IT LI LT LU LV MC MK MT NL NO
PL PT RO SE SI SK SM TR

(30) Priority: 03.07.2009  JP 2009158973
03.07.2009  JP 2009158974
03.07.2009  JP 2009158977
01.07.2010  JP 2010151461

(71) Applicant: Sharp Kabushiki Kaisha
Osaka-shi, Osaka 545-8522 (JP)

(72) Inventors:
• TAKESHIMA, Mitsuru
Osaka 545-8522 (JP)
• KATOH, Hideaki
Osaka 545-8522 (JP)
• TSUTSUI, Akio
Osaka 545-8522 (JP)

(74) Representative: Müller - Hoffmann & Partner
Patentanwälte
Innere Wiener Strasse 17
81667 München (DE)

(54) **MOUNTING SUBSTRATE FOR SEMICONDUCTOR LIGHT EMITTING ELEMENT, BACKLIGHT CHASSIS, DISPLAY DEVICE AND TELEVISION RECEIVER**

(57)    Disclosed are a mounting substrate for semiconductor light emitting elements, a backlight chassis containing the substrate, a display device and a television receiver. The manufacture of the substrate does not involve an increase in the number of steps, and the substrate has a simple structure that allows good heat dissipation of heat from semiconductor light emitting elements, and can suppress temperature increases when mounted thereupon with a flip flop-type semiconductor light emitting element. A mounting substrate (1) for semiconductor light emitting elements is provided with: pair of the electrode patterns (4, 5) that respectively connect the positive and negative electrodes of LED chips (2) on an insulating substrate (3) ; and wire patterns (6) that are drawn between the pair of the electrode patterns (4, 5). The pair of the electrode patterns (4, 5) have a larger surface area than the wire patterns (6) . This allows heat from the LED chips (2) to transfer favorably via the large electrode patterns (4, 5) to the insulating substrate (3) . The mounting substrate (1) for semiconductor light emitting elements is attached to a backlight chassis (not shown in the figure).

FIG.4

**Description**

TECHNICAL FIELD

The present invention relates to a semiconductor light emitting element mounting substrate, a backlight chassis, a display device, and a television receiver, and, more particularly, to a semiconductor light emitting element mounting substrate, a backlight chassis, a display device, and a television receiver which are preferred when a flip-chip semiconductor light emitting element is used as a backlight source of a liquid-crystal display device.

BACKGROUND ART

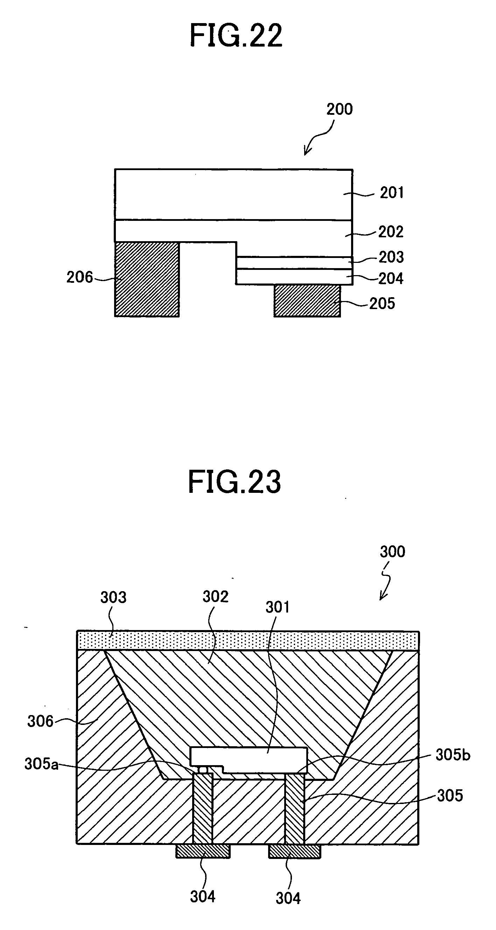

Recently, television is further made thinner and a semiconductor light emitting element, LED (Light Emitting Diode) is started to be widely used as a backlight source in liquid-crystal televisions in one technique for the thinning.
Two types of light irradiation systems for an LED backlight exist, which are a side edge type and a direct type. In the side edge type, LEDs are disposed on the side of a screen of a video display device to make light incident on a light guide plate. On the other hand, in the direct type, LEDs are disposed in a matrix (two-dimensional) shape immediately under the screen to directly utilize outgoing light. Since luminance can more easily be increased in the direct type than the side edge type, the LED backlight of the direct type is mainly employed in video display devices using a large-size liquid-crystal displaying element.
A flip-chip configuration is known that forms connection with a wiring pattern on a substrate via a solder bump or a solder ball. As compared to a face-up configuration, since the flip-chip configuration eliminates the need for wires for wiring, a wire bonding operation is not necessary and a small-size electronic part can be mounted on a substrate with a relatively simple operation. The flip-chip configuration enables a thinner configuration and is therefore considered to be applied to the LED backlight.
However, since LEDs are point light sources, the light sources must be disposed on an entire surface. Although LEDs are efficient light sources, light must be emitted at higher luminance to use LEDs for a backlight of a liquid-crystal display device. Therefore, a light source using LEDs needs measures for heat generation corresponding to a large current.
The heat generated by LED is normally conducted to a substrate with an LED chip mounted, and is released. For example, Patent Document 1 discloses a configuration having a thermal via disposed in a substrate with an LED chip mounted so as to release the heat generated by LED through this thermal via to a heat radiation pad disposed on the rear surface of the substrate. Patent Document 2 discloses an integrated circuit mounting substrate having a heat radiation pattern separately disposed in an area where no wiring pattern is formed so as to conduct heat of an integrated circuit to the heat radiation pattern by connecting a ground wiring bump and a dummy bump to the heat radiation pattern.
A configuration of a conventional flip-chip LED chip will be described with reference to Fig. 22. An LED chip 200 is made up of a sapphire substrate 201, an N-type layer 202, an active layer 203, a P-type layer 204, a positive electrode (anode electrode) 205, and a negative electrode (cathode electrode) 206.
A package-type chip configuration is depicted in Fig. 23 as a configuration of another conventional flip-chip LED chip. An LED package 300 is made up of an LED chip 301, a phosphor layer 302, a protection layer 303, bottom electrodes (positive electrode and negative electrode) 304, vias 305, contact pads 305a, 305b, and a silicon sub-mount 306 (see. e.g. , Patent Document 3).
Since it is normally only necessary to sufficiently satisfy the property of soldering in the chip configuration of LED as depicted in Fig. 22 or 23, the sizes and shapes of the positive and negative electrodes of LED are determined in consideration of a current path, a current value, etc., regardless of an amount of heat generation of the LED.

PRIOR ART DOCUMENT

Patent Documents

Patent Document 1: Japanese Laid-Open Patent Publication No. 2008-34748
Patent Document 2: Japanese Laid-Open Patent Publication No. 2005-109254
Patent Document 3: Japanese Laid-Open Patent Publication No. 2009-111006

SUMMARY OF THE INVENTION

PROBLEM TO BE SOLVED BY THE INVENTION

However, since a via hole must be disposed in a substrate and a heat radiation pad must be disposed on the rear surface of the substrate in the technique described in Patent Document 1, it is problematic that a manufacturing process is increased and causes a higher production cost. Although the technique described in Patent Document 2 can be achieved in an integrated circuit that enables arrangement of ground wiring bumps and dummy bumps, the application to bipolar elements such as LED is difficult.

Since a flip-chip LED chip has a positive electrode and a negative electrode in contact with a mount substrate, an amount of heat release from the LED chip to the mount substrate is dependent on the electrode areas of the electrodes. Since a heat generation amount is particularly large in an active layer making up the LED chip, it is considered that the LED chip can more efficiently be cooled by increasing the electrode area of the positive electrode located closer to the active layer.

Although a liquid-crystal display device is applicable as a display device to various products, heat release from a backlight portion including a light source is a main portion of heat release of an entire product. Therefore, a heat releasing means of a substrate portion with the light source mounted is highly important. However, as depicted in Fig. 22 or 23, since the sizes and shapes of the positive and negative electrodes of LED are determined in accordance with a current path, a current value, etc., in a conventional LED chip, no consideration is given to enhancement of the heat release effect from the LED chip side to the mount substrate.

The present invention was conceived in view of the situations and it is therefore an object of the present invention to provide a semiconductor light emitting element mounting substrate without increasing a manufacturing process as a substrate for mounting a flip-chip semiconductor light emitting element that favorably releases heat from the semiconductor light emitting element with a simple configuration to suppress a rise in temperature when the semiconductor light emitting element is mounted and that has enhanced credibility during manufacturing, and to provide a backlight chassis, a display device, and a television receiver that include this substrate.

MEANS FOR SOLVING THE PROBLEM

To solve the problems, a first technical means of the present invention is a semiconductor light emitting element mounting substrate for mounting a semiconductor light emitting element having a positive electrode and a negative electrode on the same plane, comprising: an insulated substrate; a pair of electrode patterns respectively connected to the positive electrode and the negative electrode on the insulated substrate; and a wiring pattern drawn out from each of the pair of the electrode patterns, wherein each of the pair of the electrode patterns having a larger area than the wiring pattern.

A second technical means is the semiconductor light emitting element mounting substrate of the first technical means, wherein the pair of the electrode patterns has facing portions facing each other in substantially parallel across a predetermined gap, and the positive electrode and the negative electrode of the semiconductor light emitting element are connected to the facing portions.

A third technical means is the semiconductor light emitting element mounting substrate of the second technical means, wherein the insulated substrate has a long strip shape, the pair of the electrode patterns extends in longitudinal direction on the insulated substrate and has different widths, and in the pair of the electrode pattern portions on which the positive electrode and the negative electrode of the semiconductor light emitting element are placed, at least one of the wider electrode pattern and the narrower electrode pattern has a projecting portion formed to project toward the other electrode pattern.

A fourth technical means is the semiconductor light emitting element mounting substrate of any one of the first technical means to third technical means, wherein out of the positive electrode and the negative electrode of the semiconductor light emitting element, the electrode on the farther side from an active layer is connected to the narrower electrode pattern.

A fifth technical means is the semiconductor light emitting element mounting substrate of the third technical means or fourth technical means, wherein a concave portion facing the projecting portion across a predetermined gap is formed on the side of the other electrode pattern.

A sixth technical means is the semiconductor light emitting element mounting substrate of the fifth technical means, wherein a gap between the projecting portion and the concave portion is positioned at substantially the center in the width direction of the pair of the electrode patterns.

A seventh technical means is the semiconductor light emitting element mounting substrate the fifth technical means or sixth technical means, wherein a cutout is formed on both longitudinal direction sides of the concave portion.

An eighth technical means is the semiconductor light emitting element mounting substrate of any one of the third technical means to seventh technical means, wherein the projecting portion has a step-like shape.

A ninth technical means is the semiconductor light emitting element mounting substrate of any one of the third technical means to eighth technical means, wherein the semiconductor light emitting element has the positive electrode and the negative electrode formed on the same surface side and has an electrode area of one electrode formed larger than an electrode area of the other electrode, and wherein the electrode with the larger electrode area is connected to the side of the wider electrode pattern.

A tenth technical means is the semiconductor light emitting element mounting substrate of the ninth technical means, wherein the electrode with a larger electrode area of the semiconductor light emitting element is closer to the active layer than the electrode with a smaller electrode area.

An eleventh technical means is the semiconductor light emitting element mounting substrate of the first technical means or second technical means, wherein the drawn-out directions of the wiring pattern drawn out from each of the pair of the electrode patterns are directions different from each other.

A twelfth technical means is the semiconductor light emitting element mounting substrate of any one of the first technical means to third technical means, wherein the insulated substrate has a long strip shape, and a gap of the pair of the electrode patterns is formed in parallel with longitudinal direction of the strip shape.

A thirteenth technical means is the semiconductor light emitting element mounting substrate of any one of the first technical means to twelfth technical means, wherein the insulated substrate has a long strip shape, and a plurality of the pairs of the electrode patterns is formed along the longitudinal direction of the strip shape to enable arrangement of a plurality of the semiconductor light emitting elements.

A fourteenth technical means is the semiconductor light emitting element mounting substrate of any one of the first technical means to thirteenth technical means, wherein when W (w) is power of the semiconductor light emitting element, S (m$^2$) is an area of the pair of the electrode patterns, L (m) is a thickness of the insulated substrate, and $\rho$ (W/(m/K)) is a thermal conductivity of the insulated substrate, an average temperature difference $\Delta T$ between one surface and the other surface of the insulated substrate calculated by $\Delta T = W \cdot L/S/\rho$ is equal to or less than 12 degrees C.

A fifteenth technical means is a backlight chassis comprising the semiconductor light emitting element mounting substrate of any one of the first technical means to fourteenth technical means.

A sixteenth technical means is a display device comprising the semiconductor light emitting element mounting substrate of any one of the first technical means to fourteenth technical means.

A seventeenth technical means is a television receiver comprising the display device of the sixteenth technical means.

EFFECT OF THE INVENTION

According to the present invention, the electrode patterns of the portion connected to the electrodes of the semiconductor light emitting element have an area larger than the wiring pattern. Therefore, the heat conducted from the semiconductor light emitting element through the electrode to the electrode patterns is released from the larger electrode patterns and is favorably conducted via the larger electrode patterns to the insulated substrate and further released via the insulated substrate. Therefore, the semiconductor light emitting element mounting substrate of the present invention can suppress a rise in temperature of the semiconductor light emitting element.

According to the present invention, since the electrode of the semiconductor light emitting element on the farther side from the active layer can be connected to the projecting portion formed on the side of the narrower electrode pattern, and the electrode of the semiconductor light emitting element closer to the active layer can be connected to the wider electrode pattern portion facing the projecting portion across a gap, the heat from the semiconductor light emitting element can efficiently be conducted from the both electrodes through the electrode patterns to the insulated substrate. Therefore, the semiconductor light emitting element mounting substrate of the present invention can efficiently suppress a rise in temperature of the semiconductor light emitting element.

Since the projecting portion is formed on the electrode pattern, the credibility of reflow can be increased when the electrodes of the semiconductor light emitting element are connected to the electrode patterns by using solder paste. According to the present invention, by increasing an electrode area of the positive electrode or the negative electrode making up the semiconductor light emitting element, the generated heat can favorably be released to the substrate side with a simple configuration to suppress a rise in temperature when the element is mounted on the substrate.

BRIEF DESCRIPTION OF DRAWINGS

[Fig. 1] Fig. 1 is an exploded perspective view of a general configuration of a television receiver according to one embodiment of the present invention.

[Fig. 2] Fig. 2 is an exploded perspective view of a general configuration of a liquid-crystal display device included in the television receiver.

[Fig. 3] Fig. 3 is a diagram of an example of using a semiconductor light emitting element mounting substrate according to the present invention with a backlight of the liquid-crystal display device.

[Fig. 4] Fig. 4 is a diagram of the semiconductor light emitting element mounting substrate according to one embodiment of the present invention.

[Fig. 5] Fig. 5 is a cross-section diagram when an LED chip is mounted on the semiconductor light emitting element mounting substrate depicted in Fig. 4.

[Fig. 6] Fig. 6 is a diagram of a model used for obtaining a change in LED temperature and a change in thermal flow rate of an electrode pattern.

[Fig. 7] Fig. 7 is a conceptual diagram when simulations of heat conduction, heat transfer, and heat radiation are performed as a thermal network.

[Fig. 8] Fig. 8 is a graph of simulation results.

[Fig. 9] Fig. 9 is a graph of a thermal flow rate value estimated as a value acquired by dividing the wattage of the LED chip by the area of the electrode pattern.

[Fig. 10] Fig. 10 is a schematic for explaining heat migration through an insulated substrate.

[Fig. 11] Fig. 11 is a graph of estimation of a relationship between an electrode pattern area and a temperature difference between one surface and the other surface of the insulated substrate.

[Fig. 12] Fig. 12 is a diagram of a semiconductor light emitting element mounting substrate according to another embodiment of the present invention.

[Fig. 13] Fig. 13 is a diagram of a semiconductor light emitting element mounting substrate according to yet another embodiment of the present invention.

[Fig. 14] Fig. 14 is a diagram of a semiconductor light emitting element mounting substrate according to still another embodiment of the present invention.

[Fig. 15] Fig. 15 is a diagram of a semiconductor light emitting element mounting substrate according to a further embodiment of the present invention.

[Fig. 16] Fig. 16 is a diagram of a cross section taken along X-X when an LED chip is mounted on the semiconductor light emitting element mounting substrate depicted in Fig. 15.

[Fig. 17] Fig. 17 is a diagram of the LED chip depicted in Fig. 16 viewed from a Y direction.

[Fig. 18] Fig. 18 is a diagram of a semiconductor light emitting element mounting substrate according to a yet further embodiment of the present invention.

[Fig. 19] Fig. 19 is a diagram of a semiconductor light emitting element mounting substrate according to a still further embodiment of the present invention.

[Fig. 20] Fig. 20 is a diagram of a cross section of a semiconductor light emitting element having an LED package configuration.

[Fig. 21] Fig. 21 is a diagram of an example of a semiconductor light emitting element mounting substrate.

[Fig. 22] Fig. 22 is a diagram of a configuration of a conventional flip-chip LED chip.

[Fig. 23] Fig. 23 is a diagram of another example of a conventional LED chip configuration.

MODES FOR CARRYING OUT THE INVENTION

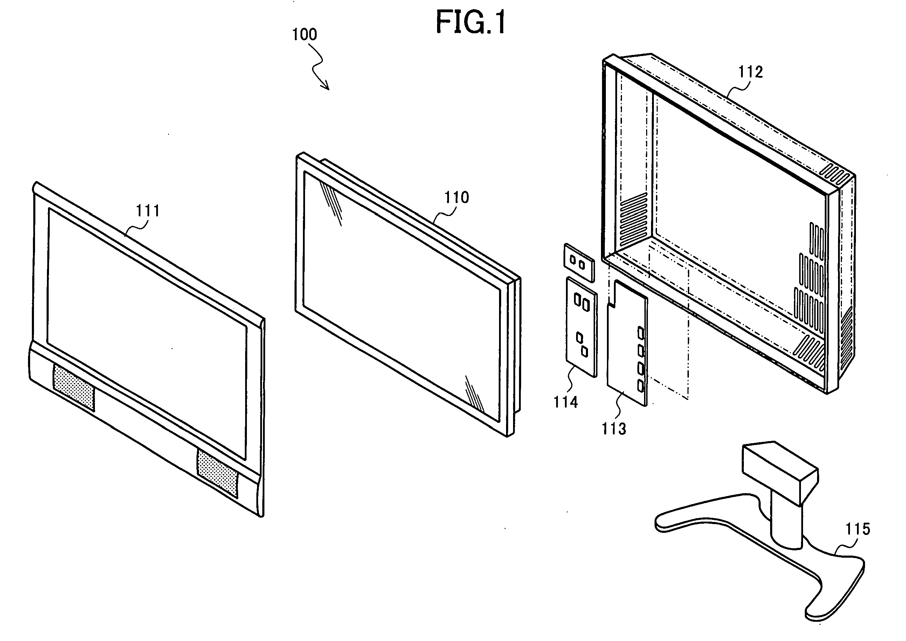

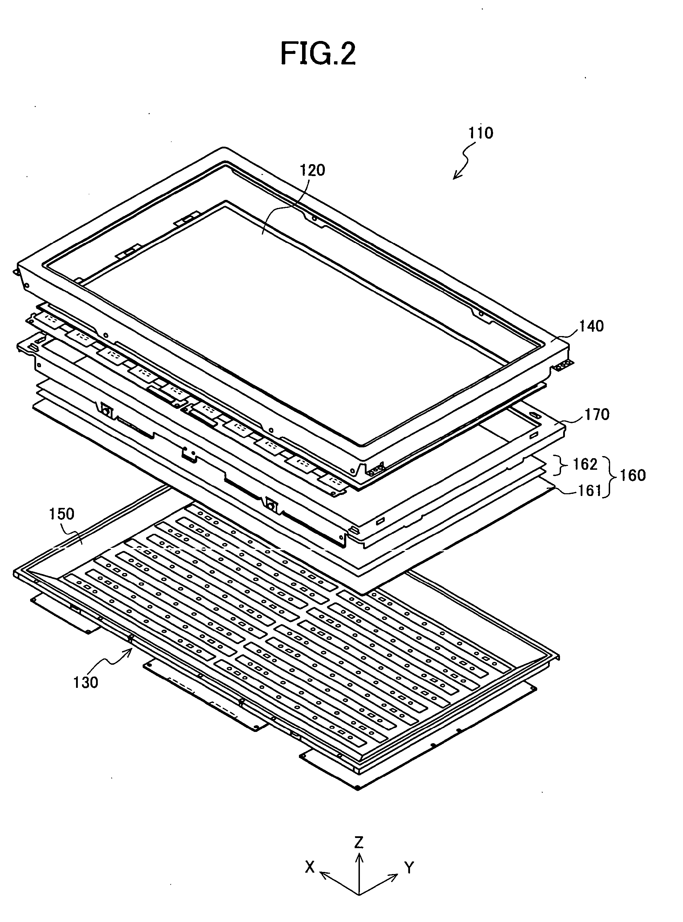

Preferred embodiments of the present invention will now be described with reference to the drawings. Fig. 1 is an exploded perspective view of a general configuration of a television receiver according to one embodiment of the present invention and Fig. 2 is an exploded perspective view of a general configuration of a liquid-crystal display device included in the television receiver.

As depicted in Fig. 1, a television receiver 100 includes a liquid-crystal display device 110, both front and back cabinets 111, 112 housing the liquid-crystal display device 110 in a sandwiching manner, a power source 113, a tuner 114, and a stand 115.

The liquid-crystal display device (display device) 110 forms a horizontally elongated square shape (rectangular shape) as a whole and is housed in a vertically standing state. As depicted in Fig. 2, the liquid-crystal display device 110 includes a liquid-crystal panel 120 that is a displaying panel and a backlight apparatus (illuminating apparatus) 130 that is an external light source, which are integrally retained by a frame-shaped bezel 140. Fig. 2 exemplarily illustrates a liquid-crystal display device having a 42-inch screen size and an aspect ratio of 16:9.

The liquid-crystal panel 120 is configured such that a pair of glass substrates laminated to each other and separated by a predetermined gap and liquid crystal is enclosed between the both glass substrates. One of the grass substrates is provided with a switching element (e.g., TFT) connected to a source wiring and a gate wiring orthogonal to each other, a pixel electrode connected to the switching element, an oriented film, etc. The other grass substrate is provided with a color filter having colored portions of R (red), G (green), B (blue), etc., disposed in a predetermined arrangement, an opposite electrode, an oriented film, etc.

As depicted in Fig. 2, the backlight apparatus 130 has a substantially box-shaped backlight chassis 150 opened toward a light emitting surface (toward the liquid-crystal panel 120), and an optical member 160 consisting of a diffusion plate 161 attached in such a way as to cover an opening portion of the backlight chassis 150 and an optical sheet set 162 disposed closer to the light emitting surface than the diffusion plate 161. The optical member 160 is retained by the backlight chassis 150 and a frame 170 disposed along the circumference of the backlight chassis 150.

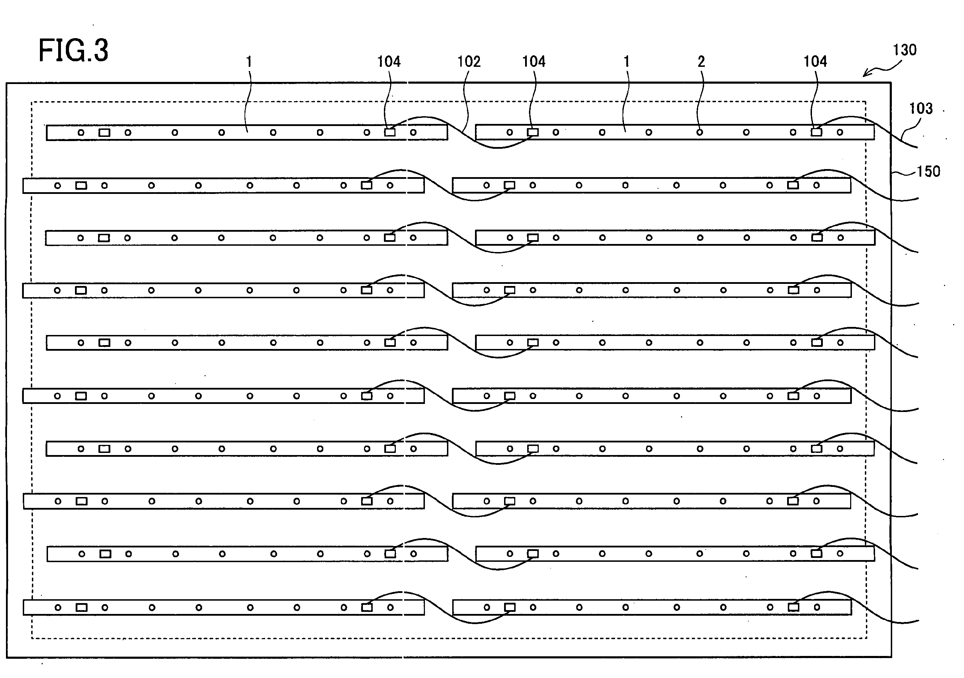

Fig. 3 is a diagram of an example of using a semiconductor light emitting element mounting substrate according to the present invention with the backlight apparatus of the liquid-crystal display device.
The backlight apparatus 130 has a plurality of semiconductor light emitting element mounting substrates (hereinafter referred to as LED substrates) 1 according to the present invention disposed on the backlight chassis 150. Each of the LED substrates 1 has a plurality of LED chips 2 mounted in a linear shape (an array shape), has a long strip shape, and is disposed such that the longitudinal direction thereof matches the horizontal direction of a screen of the liquid-crystal display device.

Fig. 3 exemplarily illustrates the array-type LED backlight apparatus 130 applied to a video display device with a 42-inch wide screen (width 930 mm x height 523 mm) . In general, the LED substrates 1 have maximum vertical and horizontal outside dimensions at the time of manufacturing, i.e., standard lengths. Although the standard lengths are different depending on material or manufacturing apparatus of the LED substrates 1, the standard lengths are a height of 510 mm and a width of 340 mm, for example.

Therefore, if vertical or horizontal dimension of the LED substrate 1 exceeds the standard length, the mount substrate 1 is divided into a several parts for manufacturing. In the case of Fig. 3, since the standard lengths are exceeded, the mount substrate is divided into two parts in the horizontal direction so as to dispose two substrates in the horizontal direction and ten substrates in the vertical direction such that a total of the 20 LED substrates 1 are arranged. Each of the LED substrates 1 has eight LEDs 2 disposed in linear arrangement, for example.

Therefore, in the backlight apparatus 130 of Fig. 3, a total of the 160 LED chips 2 are used in the entire screen. In Fig. 3, a distance between the adjacent LED chips 2 is set to 60 mm and the LED chips 2 are generally arranged in a hexagonal lattice shape. In the arrangement in the hexagonal lattice shape, a virtual regular hexagon is formed around one of the LED chips 2, and other LED chips 2 are arranged at the apexes of the regular hexagon. As a result, the LED backlight apparatus 130 can apply uniform backlight to a liquid crystal panel.

Ten harnesses 102 are provided so as to form electric connection between the LED substrates 1 divided into two parts in the horizontal direction. Ten harnesses 103 are also provided so as to electrically connect one of the LED substrates 1 to an external driver substrate not depicted. These harnesses 102 and 103 are connected to connectors 104 disposed on the LED substrates 1.

The backlight apparatus 130 disposed on the rear surface of the liquid-crystal panel 120 includes a matrix-type LED backlight apparatus made up by arranging a multiplicity of LED chips in a matrix shape all over a substrate having substantially the same area as a screen size. However, since the matrix-type LED backlight apparatus needs the substrate having substantially the same area as the screen size, prices of members become very expensive. On the other hand, in the case of the array-type LED backlight apparatus, although a plurality of the LED substrates 1 is necessary, the LED substrates 1 are arranged at intervals from each other and, therefore, the larger-screen liquid-crystal display device can inexpensively be manufactured as compared to the matrix-type LED backlight apparatus. The array-type LED backlight apparatus is applicable to various screen sizes by increasing/decreasing the number of the LED substrates 1 in accordance with a screen size.

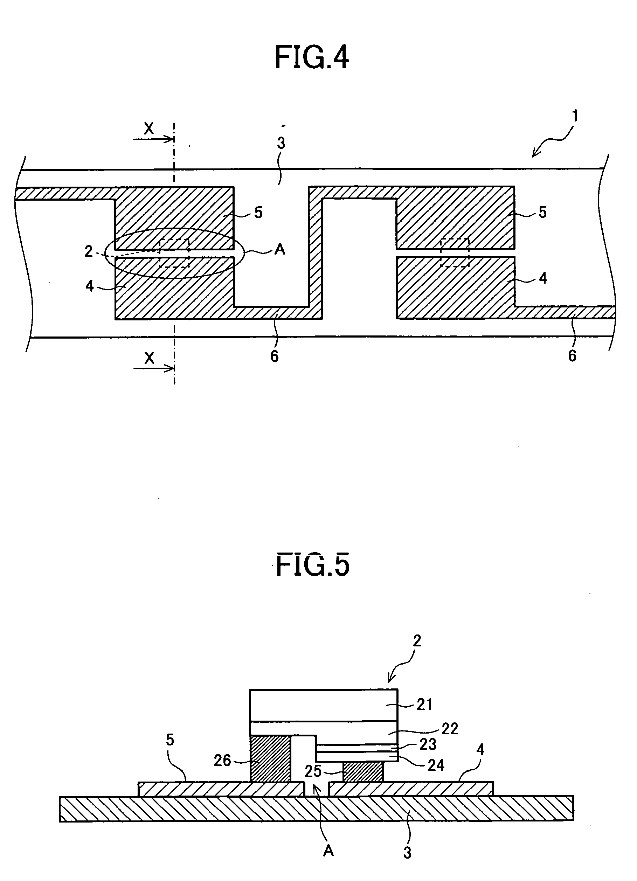

Fig. 4 is a diagram of the semiconductor light emitting element mounting substrate according to one embodiment of the present invention.
The LED substrate 1 has a pair of rectangular electrode patterns 4, 5 for connecting electrodes of an LED chip described later, and a wiring pattern 6 drawn out from each of a pair of the electrode patterns 4, 5, on an insulated substrate 3 having a long strip shape and made of epoxy resin etc. Although a pair of the electrode patterns 4, 5 is formed with substantially the same thickness as the wiring pattern 6, a pair of the electrode patterns 4, 5 is formed with an area larger than the wiring pattern 6.

A pair of the electrode patterns 4, 5 has facing portions A facing each other in substantially parallel across a predetermined gap, and the LED chip 2 is mounted on the facing portions A by using solder etc. The LED chip 2 is placed on substantially the center in the width direction of the strip-shaped LED substrate. In the LED substrate 1 depicted in Fig. 4, the facing portions A are formed along the longitudinal direction of the LED substrate 1 (the horizontal direction of Fig. 4) . The drawn-out directions of the wiring pattern 6 drawn out from each of a pair of the electrode patterns 4, 5 are directions different from each other.

If the facing portions A are formed along the longitudinal direction of the LED substrate 1 in this way, each of the positive and negative electrodes of the LED chip 2 mounted on the facing portions A can be elongated in the placement length along the longitudinal direction of the LED substrate 1. Therefore, if the LED substrate 1 is bent in the longitudinal direction during handling, a smaller stress is applied to a connecting portion between the electrodes of the mounted LED chip 2 and the electrode patterns 4, 5 of the LED substrate 1, thereby reducing connection failures of the LED chips.

Although the width of the wiring pattern 6 is determined based on the maximum value of a current applied to the LED chip 2, the area of the electrode patterns 4, 5 is determined from a rise in temperature when the current of the maximum value is applied to the LED chip 2 as described later. With regard to the distinction between the electrode patterns 4, 5 and the wiring pattern 6, the wiring pattern 6 is a narrower portion orthogonal to the current flowing direction, and the electrode patterns 4, 5 are distinguished as wider portions orthogonal to the current flowing direction if the facing portions A with the LED chip 2 mounted are shorted.

In the LED substrate depicted in Fig. 4, the electrode patterns 4, 5 and the wiring pattern 6 are made of copper (Cu) . In a method of forming the electrode patterns 4, 5 and the wiring pattern 6, both may be formed by etching from a copper foil disposed on the insulating substrate 3, and various generic methods can be used as well. The electrode patterns 4, 5 and the wiring pattern 6 may be made of a metal foil of material other than copper, for example, gold (Au), silver (Ag), or aluminum (Al) .

Fig. 5 is a diagram of a cross section taken along X-X when an LED chip is mounted on the semiconductor light emitting element mounting substrate depicted in Fig. 4.

By way of example, the LED chip 2 has a configuration with an AlInGa-based N-type layer 22, an active layer 23, and a P-type AlInGaN layer 24 stacked on an insulative transparent sapphire substrate 21. An anode-side positive electrode 25 disposed on the P-type layer 24 and a cathode-side negative electrode 26 disposed on the N-type layer 22 are respectively connected to a pair of the electrode patterns 4, 5, and a forward current is applied from the positive electrode 25 to the negative electrode 26 to cause the active layer 23 to emit light, which is taken out through the sapphire substrate 21 to the outside.

As described above, the flip-chip LED chip 2 is configured such that the positive electrode 25 and the negative electrode 26 formed on the LED chip 2 are directly opposed, closely attached, and jointed to the respective electrode patterns 4, 5 of the LED substrate 1 without using a bonding wire or a lead. The configuration of the LED chip 2 is not limited to this example and may have any configuration as long as the configuration is the flip-chip type.

When the forward current is applied to the LED chip 2 to cause light emission, the heat generated from the LED chip 2 is conducted from the positive electrode 25 and the negative electrode 26 to the respective electrode patterns 4, 5 and is further conducted through the electrode patterns 4, 5 to the insulated substrate 3. Since the insulated substrate 3 is attached to a backlight chassis not depicted (the backlight chassis 150 depicted in Fig. 3), the heat is further conducted through the insulated substrate 3 to the backlight chassis. Since the areas of the electrode patterns 4, 5 are widened in the portions on which the LED chip 2 is placed in the present invention, the heat from the LED chip 2 is released from the electrode patterns 4, 5 to the outside and is also conducted through the wider areas to the insulated substrate 3 and, therefore, the heat is favorably conducted to the backlight chassis, thereby suppressing a rise in temperature of the LED chip 2.

Although it is generally known that heat from a heat generation source has a heat radiation efficiency changing depending on size and thickness of a substrate, if a large current is applied to a point light source element such as LED, an electrode portion of the LED chip reaches extremely high temperature and the temperature distribution in the vicinity of the electrode is significantly affected by sizes and shapes of electrode patterns and wiring patterns. If the insulated substrate is made of epoxy resin and the electrode patterns 4, 5 are made of copper (Cu), since the thermal conductivities of epoxy resin and copper are about 1 W/ (m·K) and about 400 W/(m·K), respectively, the distribution of heat flux conducted from the LED chip 2 to the insulated substrate 3 is significantly changed depending on the sizes and shapes of the electrode patterns 4, 5 and a wider electrode pattern can release a larger heat amount to the insulated substrate 3.

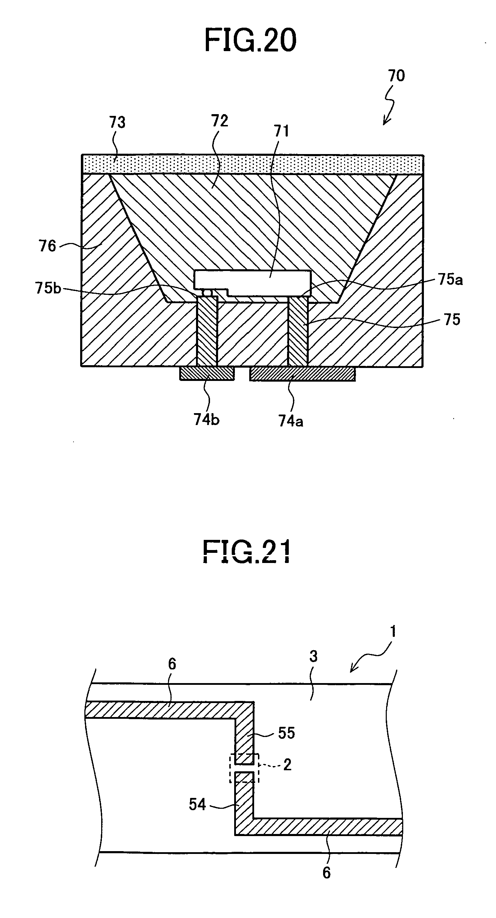

For example, since the width of electrode patterns 54, 55 is the same as the width of the wiring pattern 6 in the LED substrate 1 depicted in Fig. 21, the heat from the LED chip 2 is not sufficiently conducted via the electrode patterns 54, 55 to the insulated substrate 3. Therefore, the temperature distribution of the LED chip 2 is extremely high in the vicinity of the LED chip 2, deteriorating the light emission efficiency of the LED chip 2. A current value applicable to the LED chip 2 must be suppressed to a lower level.

For a model acquired by forming an electrode pattern on an insulated substrate and mounting an LED chip on this electrode pattern, the LED chip was used as a heat source to obtain a change in LED temperature and a change in thermal flow rate of the electrode pattern when a size of the electrode pattern was changed by using a thermal network.

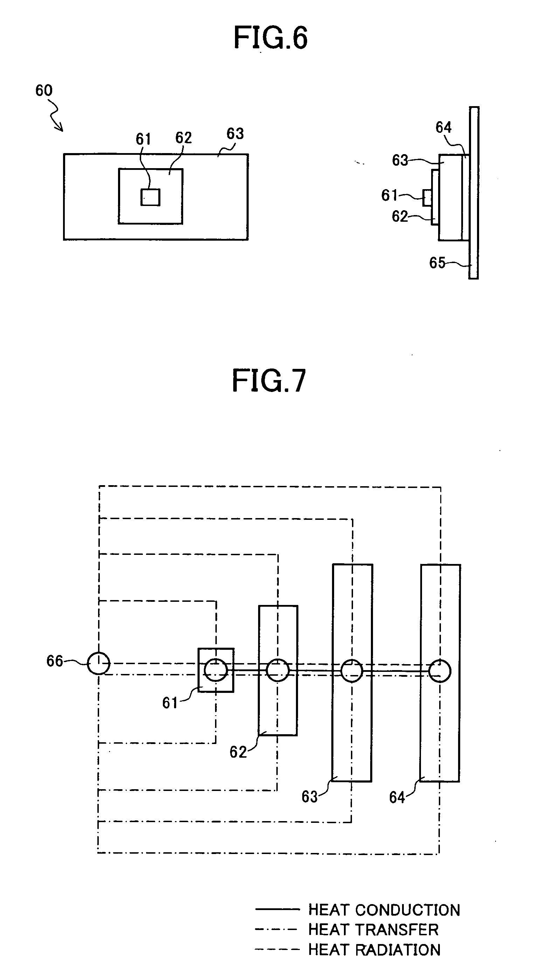

Fig. 6 is a diagram of the model used for obtaining the change in LED temperature and the change in thermal flow rate of the electrode pattern.

A model 60 is formed by sequentially stacking a backlight chassis 65, a rear surface pattern 64, an insulated substrate 63, an electrode pattern 62, and an LED chip 61.

The specifications of the members making up the model 60 are as follows.

The LED chip 61 has a square shape with a side of 2.8 mm and a power of 0.68 W.

The electrode pattern 62 is a copper foil with a thickness of 35 $\mu$m and has a thermal conductivity of 390 W/(m·K).

The insulated substrate 63 is a high thermal conductivity type and has a thickness of 1 mm, an area of 50 mm x 30 mm, and a thermal conductivity of 1 W/(m·K).

The rear surface pattern 64 is a copper foil with a thickness of 35 $\mu$m and has a thermal conductivity of 390 W/ (m. K) and the same area as the insulated substrate 63, and the rear surface pattern 64 is disposed on the entire rear surface of the insulated substrate 63.

The backlight chassis 65 is made of iron and has a thickness of 0. 8 mm, a thermal conductivity of 50 W/(m·K), and a sufficient area.

The change in LED temperature and the change in thermal flow rate of the electrode pattern were obtained through simulations when the area of the electrode pattern 62 was changed from a 6-mm square to a 15-mm square at 1 mm internal on a side.

Fig. 7 is a conceptual diagram when simulations of heat conduction, heat transfer, and heat radiation are performed as a thermal network. The simulations were performed for heat conduction, heat transfer, and heat radiation as depicted in Fig. 7. The heat conduction is thermal migration mainly occurring within substance and the heat transfer is thermal migration mainly occurring on a surface of substance. The heat radiation is thermal migration as a heat ray. In the simulations, the temperature of the LED chip 61 and the thermal flow rate of the electrode pattern 62 were obtained when the temperature of air 66 was 25 degrees C. However, the temperature of the LED chip 61 was assumed to be equal to the average temperature of the electrode pattern 62.

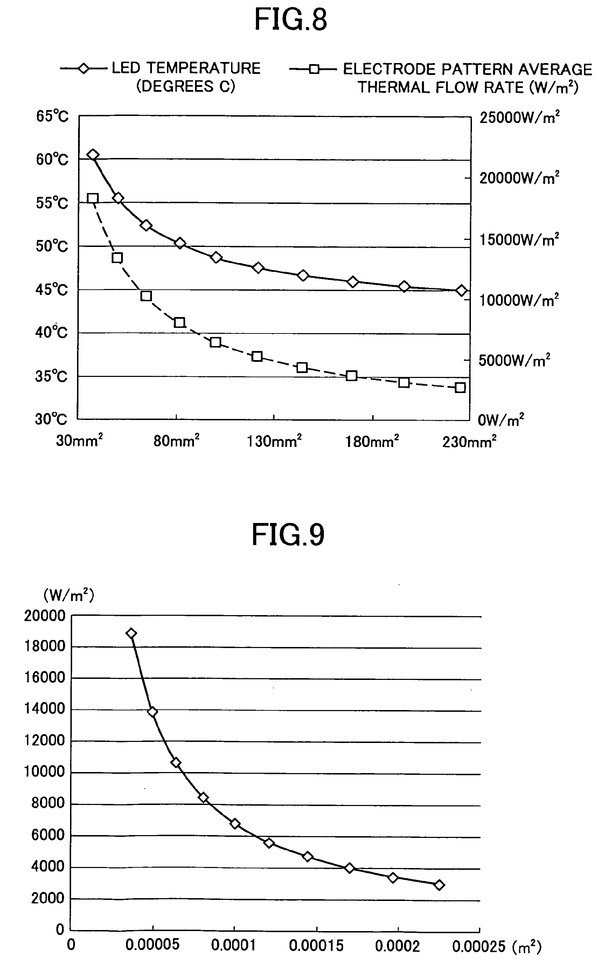

Fig. 8 is a graph of simulation results and is a diagram with an X-axis defined as the area of the electrode pattern 62 and a Y-axis defined as the temperature of the LED chip 61 (average temperature of the electrode pattern 62) and the average thermal flow rate of the electrode pattern 62.

The thermal flow rate is a migration amount of heat per unit area. When the thermal flow rate is larger, an amount of change in temperature per unit area is correspondingly increased. Therefore, if the thermal flow rate value on the electrode pattern 62 can be lowered, the amount of change in temperature is reduced and the temperature of the LED chip 61 is consequently lowered.

In Fig. 8, the average temperature of the rear surface pattern 64 is about 42.3 degrees C and is substantially the same in each electrode pattern. In Fig. 8, plots are made for the electrode pattern 62 of the 6-mm side square, the 7-mm side square, ... the 15-mm side square in the order from the leftmost mark.

The electrode pattern 62 of the 6-mm side square corresponds to the LED chip temperature of about 60 degrees C and the thermal flow rate of 18000 W/m$^2$, and both the temperature of the LED chip and the thermal flow rate of the electrode pattern are reduced as the area of the electrode pattern 62 increases. After the electrode pattern of the square with a side of about 11 mm, the change in temperature becomes smaller and it can be seen that a saturated state is attained.

The LED chip temperature (electrode pattern temperature), the rear surface pattern temperature, and the thermal flow rate are plotted as average values in the simulations, and the temperatures etc., are estimated on the basis of average values to simplify calculations.

With regard to the thermal migration of the LED chip 61 and the electrode pattern 62, the heat conduction is predominant, and the rate of the heat transfer and the heat radiation often remains at several percent. Therefore, it is thought that a significant difference is not made as a result even if only the heat conduction is considered.

Considering only the heat conduction, the heat from the LED chip 61 spreads across the portion disposed with the electrode pattern 62 on the front side of the insulated substrate 63. This is because the thermal conductivity of the electrode pattern 62 is considerably higher than the thermal conductivity of the insulated substrate 63.

Fig. 9 is a graph of a thermal flow rate value estimated as a value acquired by dividing the wattage of the LED chip by the area of the electrode pattern.

It can be seen that the thermal flow rates of Figs. 8 and 9 are substantially the same values.

It is then considered that after the heat of 0.68 W of the LED chip spreads across the portion disposed with the electrode pattern on the insulated substrate 63, the heat migrates toward the side of the insulated substrate 63 having the lower thermal conductivity.

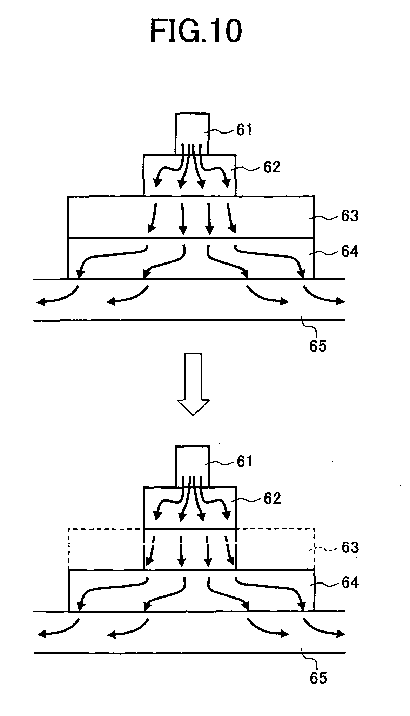

Fig. 10 is a schematic for explaining heat migration through the insulated substrate.

The thermal conductivity of the insulated substrate 63 is 1 W/(m·K), which is extremely low, even in the case of a high thermal conductivity type. On the other hand, since the rear surface pattern 64 on the rear surface side of the insulated substrate 63 has 390 W/(m·K), a much more amount of the heat on the insulated substrate 63 migrates toward the rear surface side of the insulated substrate 63 as compared to an amount of the heat migrating in the longitudinal direction (planar direction) of the insulated substrate 63. In other words, it can be estimated that a large portion of the heat migrates as depicted in Fig. 10. Therefore, it can be estimated that a portion of the insulated substrate 63 without the electrode pattern 62 does not contribute to the heat release through the heat conduction from the LED chip 61 to the backlight chassis 65.

Therefore, it can be said in another way that changing the area of the electrode pattern 62 is equivalent to changing the area of the insulated substrate 63 that conducts the heat. On this occasion, the thermal resistance value of the insulated substrate 63 can be calculated from the area of the electrode pattern 62, the thickness of the insulated substrate 63, and the thermal transmission rate of the insulated substrate 63. This is because it is assumed that the heat of the LED chip 61 is equalized in the electrode pattern 62.

Estimating a temperature difference ΔT between one surface and the other surface of the insulated substrate 63, this is expressed by the following equation:

$$\text{a temperature difference } \Delta T = W \cdot R \quad (1)$$

where R is a thermal resistance value (length/cross-section area/thermal conductivity).

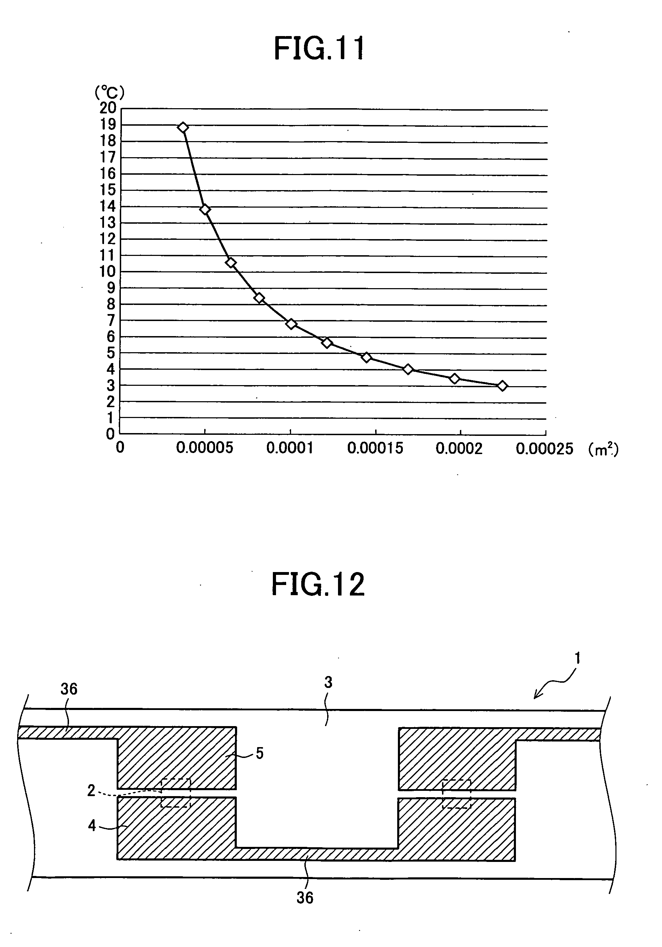

Fig. 11. is a graph of estimation of a relationship between an electrode pattern area and a temperature difference between one surface and the other surface of the insulated substrate, and the temperature difference is plotted for the areas of the electrode pattern 62 from a 6-mm square to a 15-mm square at 1 mm internal on a side on the assumption that the power W of the LED chip 61 is 0.68 W. It can be seen that the change in the LED chip temperature depicted in Fig. 8 is substantially the same as an amount of the change in the temperature difference between one surface and the other surface of the insulated substrate depicted in Fig. 11.

The temperature difference ΔT is expressed by a power W (w) of a heat generation source, an area S ($m^2$) of an electrode pattern, a thickness L (m) of an insulated substrate, and a thermal conductivity p (W/(m/K)) as follows:

$$\Delta T = W \cdot L / S / \rho \quad (2)$$

By way of example, a relationship between the electrode pattern area S and ΔT will be examined when the power W of the heat generation source is 0.68 W, the thickness L of the insulated substrate 63 is 1 mm, and the thermal conductivity p of the insulated substrate 63 is 1 W/(m·K).
First, the case of a 6-mm square is considered as a normally used electrode pattern.
The area S of the electrode pattern is 36 $mm^2$.
The temperature difference ΔT in this case is as follows.

$$\Delta T = 0.68 \times 0.001 / 0.000036 / 1.0 = 18.8 \text{ degrees C}$$

The electrode pattern of a 6-mm square is substantially equivalent to an area of a normal electrode pattern. Therefore, this temperature difference of 18.8 degrees C is considered as a temperature difference when the present invention is not used.

Since the temperature simulation of Fig. 8 reveals that the size of the electrode pattern is about 11-mm square when the temperature is being saturated, ΔT in this case is then calculated. The area S of the electrode pattern is 121 $mm^2$.

$$\Delta T = 0.68 \times 0.001 / 0.000121 / 1.0 = 5.6 \text{ degrees C}$$

From this temperature difference of 5.6 degrees C, it is considered that the heat is effectively released in accordance with the relationship between the electrode pattern and the insulated substrate. Therefore, if the average temperature difference is equal to or less than 6 degrees C, it is considered that the heat is most effectively released.
The boundary between the case of the normal electrode pattern and the case of the electrode pattern conscious of heat release is considered to exist near the middle of these temperature differences. Assuming that the intermediate temperature difference ΔT1 is in the middle of 18.8 degrees C and 6 degrees C, the intermediate temperature difference is ΔT1=12.2 degrees C, and the boundary is about 12 degrees C.
Therefore, if ΔT obtained from Equation 2 is greater than 12 degrees C, the pattern falls within a range of the normal electrode pattern and if equal to or less than 12 degrees C, the pattern is considered as the electrode pattern conscious of heat release.

By way of example, assuming that the temperature of the backlight chassis 65 is 60 degrees C when applying current, the area of the electrode pattern is calculated for suppressing the temperature of the electrode pattern 62 to + 5 degrees C, i.e., 65 degrees C.
When the power W of the heat generation source is 0.68 W, the thickness L of the insulated substrate 63 is 1 mm, and the thermal conductivity p of the insulated substrate 63 is 1 W/(m·K), the electrode pattern area S can be calculated for setting the temperature difference between one surface and the other surface of the insulated substrate to 5 degrees C or less by deforming Equation 2 as follows:

$$S=W \cdot L / \rho / \Delta T \qquad (3).$$

When the values are assigned,

$$S=0.68 \cdot 0.001/1/5$$

$$=136 \text{ mm}^2 \text{ (11.6-mm side square)},$$

and

therefore, the electrode pattern may be a square with a side of 11. mm or greater.

To establish Equation 2, the following requirements must be satisfied.

(1) The substrate, is a high thermal conductivity member.
This is because if the thermal conductivity of the substrate is extremely low, the heat from the electrode pattern does not flow to the substrate and the heat is not smoothly released.
(2) A heat release member is attached to the rear surface of the substrate. Alternatively, the rear surface is in contact with a heat releasing portion such as a backlight chassis.
This is because if the heat of the substrate is not smoothly discharged from the rear surface, a difference between the temperature of the electrode patter and the temperature of substrate rear surface increases and a difference from an estimate value increases.

In a liquid-crystal display device, a backlight chassis is usually covered with a back cover and has a configuration of releasing heat to the outside through convection between the back cover and the backlight chassis. Considering effects on a power source and electronic parts such as a control circuit disposed in the liquid-crystal display device, it is desirable to make the temperature of the backlight chassis equal to or less than about 60 degrees C. It is desirable to keep the temperature difference between the front and rear sides of the LED substrate within 5 degrees C.

Fig. 12 is a diagram of a semiconductor light emitting element mounting substrate according to another embodiment of the present invention.
In the LED substrate 1 depicted in Fig. 12, the wiring pattern 6 of the LED substrate 1 depicted in Fig. 4 is changed to a wiring pattern 36. Since the wiring pattern 36 connects the same sides of the adjacent electrode patterns 4, 5 in the width direction, i.e., connects the upper side to the upper side and the lower side to the lower side, the LED chips 2 placed on the electrode patterns 4, 5 are disposed such that the positive electrode and the negative electrode are alternated between adjacent LED chips.

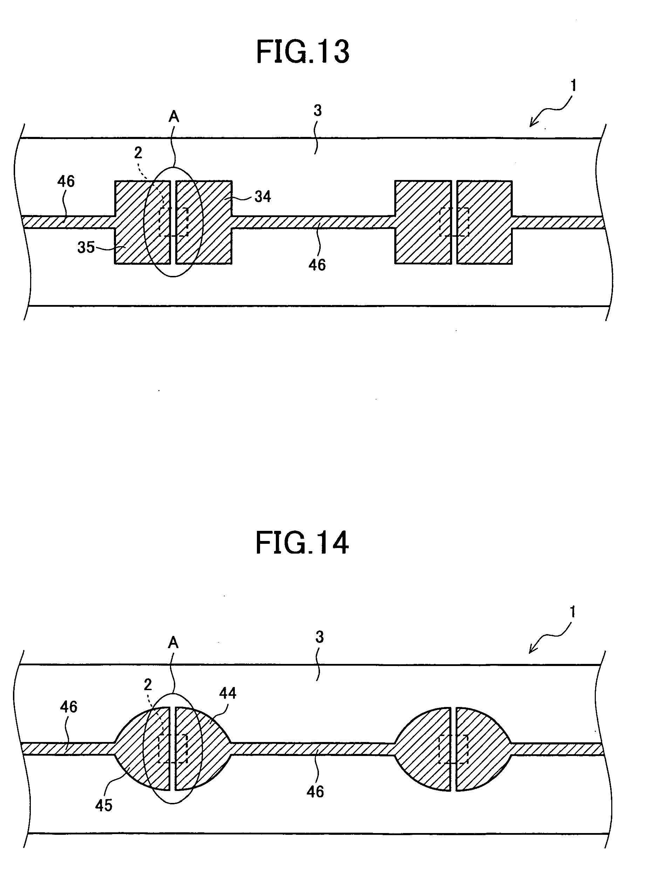

Fig. 13 is a diagram of a semiconductor light emitting element mounting substrate according to yet another embodiment of the present invention.
The LED substrate 1 depicted in Fig. 13 has a pair of rectangular electrode patterns 34, 35 for connecting electrodes of the LED chip 2, and a wiring pattern 46 drawn out from each of a pair of the electrode patterns 34, 35, on the insulated substrate 3 having a long strip shape and made of epoxy resin etc. Although a pair of the electrode patterns 34, 35 is formed with substantially the same thickness as the wiring pattern 46, a pair of the electrode patterns 34, 35 is formed with an area larger than the wiring pattern 6.

A pair of the electrode patterns 34, 35 has the facing portions A facing each other in substantially parallel across a predetermined gap, and the LED chip 2 is mounted on the facing portions A. The LED chip 2 is placed on substantially the center in the width direction of the strip-shaped LED substrate and the electrodes of the LED chip 2 are disposed along the longitudinal direction of the LED substrate 1. Although the specific shapes of the electrode patterns and the wiring pattern are different, the LED substrate 1 depicted in Fig. 13 has the mechanism of heat release from the LED chip 2 and other configurations same as the LED substrate 1 depicted in Fig. 4 and, therefore, will not be described in detail.

Fig. 14 is a diagram of a semiconductor light emitting element mounting substrate according to still another embodiment of the present invention.
Although the LED substrate 1 depicted in Fig. 14 has a configuration different from the LED substrate 1 depicted in Fig. 13 in that a pair of electrode patterns 44, 45 has a semicircle shape, the other configurations are the same.
Although the LED chip 2 is placed on the substantially parallel facing portions A of a pair of the electrode patterns 44, 45, the heat from the LED chip 2 is radially conducted around the electrode portion of the LED chip 2 and, therefore, the heat in the vicinity of the LED chip 2 is prevented from rising by forming the electrode patterns 44, 45 into a circular arc shape.

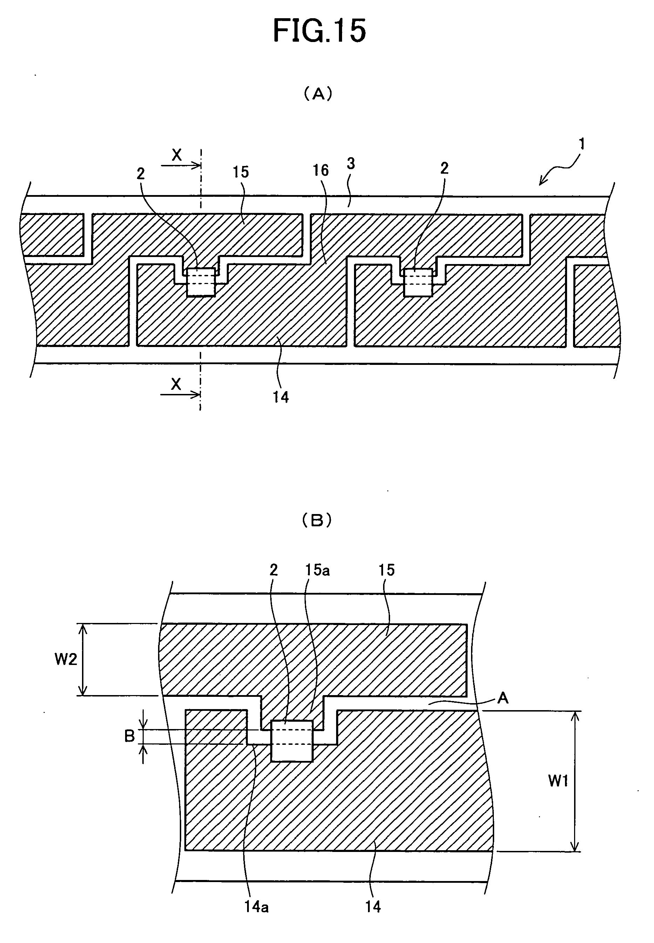

Fig. 15 is a diagram of a semiconductor light emitting element mounting substrate according to a further embodiment of the present invention, Fig. 15 (A) is a schematic of a portion of the semiconductor light emitting element mounting substrate, and Fig. 15 (B) is an enlarged view of a portion of Fig. 15 (A) .

The LED substrate 1 has a pair of electrode patterns 14, 15 for connecting electrodes of an LED chip described later on the insulated substrate 3 having a long strip shape and made of epoxy resin etc., and each of the electrode patterns 14, 15 extends in the longitudinal direction. A width W1 of the one electrode pattern 14 is formed about twice as wide as a width W2 of the other electrode pattern 15, for example.

A pair of the electrode patterns 14, 15 has the facing portions A facing each other in substantially parallel across a predetermined gap; a projecting portion 15a is formed in the facing portion A, projecting from the narrower electrode pattern 15 toward the wider electrode pattern 14; and a concave portion 14a is formed on the side of the wider electrode pattern 14, facing the projecting portion 15a across a predetermined gap B.

The electrodes of the flip-chip LED chip 2 are connected by using solder etc., to the projecting portion 15a of the electrode pattern 15 and a portion with the concave portion 14a formed in the electrode pattern facing the projecting portion 15a across the gap B. Since the gap B between the projecting portion 15a of the electrode pattern 15 and the concave portion 14a of the electrode pattern facing the projecting portion 15a is positioned at substantially the center in the width direction of the pair of the electrode patterns, the LED chip 2 is also placed on substantially the center in the width direction of the pair of the electrode patterns.

The width W1 of the electrode pattern 14 and the width W2 of the electrode pattern 15 are differentiated so as to efficiently conduct the heat from the LED chip 2 via the electrode patterns 14, 15 to the insulated substrate 3 as described later, and the projecting portion 15a is provided so as to enhance credibility in a reflow operation when the LED chip 2 is connected to the electrode patterns 14, 15 with solder paste.

On the LED substrate 1 depicted in Fig. 15, a plurality of pairs of the electrode patterns 14, 15 is formed along the longitudinal direction of the insulated substrate 3 such that a plurality of the LED chips 2 can be mounted. The wider electrodes 14 and the narrower electrodes 15 are formed on the same respective sides in the width direction of the insulated substrate 3, and the wider electrodes 14 are linked through wiring patterns 16 to the narrower electrodes 15 adjacent in the longitudinal direction such that the mounted LED chips 2 are series-connected. The width 16 of the wiring patterns is narrower than the width of the electrode patterns 14, 15 and the area of the wiring patterns 16 is smaller than the area of the electrode patterns 14, 15.

Since the electrodes of the LED chip 2 are placed across the gap B oppositely in the width direction of the LED substrate 1, each of the positive and negative electrodes of the LED chip 2 can be elongated in the placement length along the longitudinal direction of the LED substrate 1 and, if the LED substrate 1 is bent in the longitudinal direction during handling, a smaller stress is applied to the connecting portion between the electrodes of the mounted LED chip 2 and the electrode patterns 14, 15 of the LED substrate 1, thereby reducing connection failures of the LED chips 2.

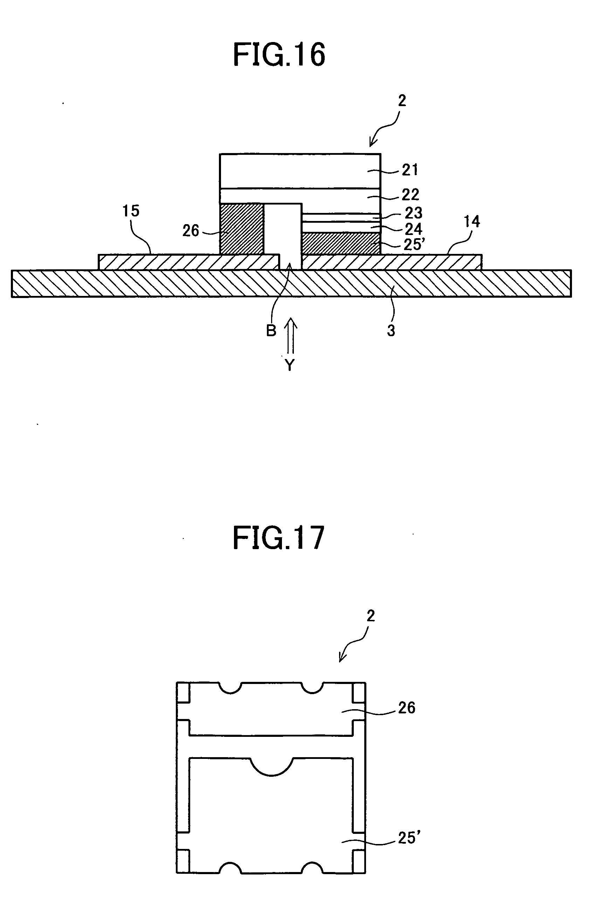

Fig. 16 is a diagram of a cross section taken along X-X when an LED chip is mounted on the semiconductor light emitting element mounting substrate depicted in Fig. 15(A). Fig. 17 is a diagram of the LED chip depicted in Fig. 16 viewed from a Y direction.

Although the configuration of the LED chip 2 is basically the same as the configuration of the LED chip 2 depicted in Fig. 5 and will not be described in detail, an area of a positive electrode 25' disposed on the P-type layer 24 is made larger than an area of a negative electrode disposed on the N-type later 22 in this embodiment because of a reason described later.

The positive electrode 25' and the negative electrode 26 are also called as bump electrodes and made of material capable of forming favorable ohmic contact with the P-type layer and the N-type layer, respectively, of the LED chip 2 and a multilayer electrode configuration can be employed if the LED chip 2 is made of compound semiconductor material. A forward current is applied from the positive electrode 25' to the negative electrode 26 to cause the active layer 23 to emit light, which is taken out through the sapphire substrate 21 to the outside.

Soldering in a reflow method is performed to closely attach and joint the positive electrode 25' and the negative electrode 26 of the LED chip 2 to the electrode patterns 14, 15.

In this method, first, solder pastes are printed in advance on the portions of the pattern electrodes 14, 15 to which the positive electrode 25' and the negative electrode 26 are respectively attached and, the LED chip 2 is placed on the LED substrate 1 with the positive electrode 25' and the negative electrode 26 respectively positioned on the printed solder pastes. Subsequently, the LED substrate 1 and the LED chip 2 are preheated in a reflow furnace. The preheating temperature is generally on the order of 150 to 170 degrees C. The temperature is then increased for main heating to a temperature for melting solder for a short time to solder the pattern electrodes 4, 5 and the electrodes of the LED chip 2. Although the melting temperature varies depending on component composition of solder, the main heating is generally performed at 220 to 260 degrees C.

The main heating must be performed for a short time so as to reduce effects of heat on the LED element 2 and the LED substrate 1 and the LED substrate 1 depicted in Fig. 15 is provided with the projecting portion 5a to rapidly raise the portion with the solder paste printed to high temperature.

Although the requirement of effectively releasing heat from the LED chip 2 during the drive of the LED chip 2 contradicts the requirement that the temperature must rapidly be raised at the time of the reflow in the portions of the electrode patterns on which the electrodes of the LED chip 2 are placed, since the time of the high temperature state in the reflow is extremely short (about ten seconds) and the temperature during the drive of the LED chip 2 is lower than the temperature at the time of the reflow, the effect on heat release from the projecting portion 15a of the electrode pattern 15 is not significant during the drive of the LED chip 2.

Considering the heat generation in the LED chip 2, a current flows through a route of the electrode pattern 14, the positive electrode 25', the P-type layer 24, the active layer 23, the N-type layer 22, the negative electrode 26, and the electrode pattern 5 and heat is generated in each of the portions, and it is thought that greater heat is mainly generated in the active layer 23. In the case of the flip-chip LED chip 2 depicted in Fig. 16, the positive electrode 25' can be disposed on the entire surface of the P-type layer 24, but the negative electrode 26 can only be disposed on a portion of the exposed surface of the N-type layer 22 in consideration of insulation.

Therefore, the heat from the LED chip 2 can more efficiently be released by releasing from the side of the electrode closer to the active layer 23, i.e., releasing from the positive electrode 25' to the outside in the case of the LED chip 2 depicted in Fig. 16, rather than releasing from the negative electrode 26 to the outside. Therefore, in the LED chip 2 depicted in Fig. 5 or 16, it can be said that the positive electrode 25, 25' is an electrode having a greater heat release effect than the negative electrode 26.

Therefore, in this embodiment, the width of the electrode pattern 14 connected to the positive electrode 25' closer to the active layer 23 is made greater than the width of the electrode pattern 15 connected to the negative electrode 26 so as to effectively conduct the generated heat from the LED 2 via the electrode patterns 14, 15 to the insulated substrate 3. In other words, one of the electrodes of the LED chip 2 having a greater heat release effect is connected to the side of the wider electrode pattern.

In the case of blue LED using GaN, the P-type layer 24 has a lower electric conductivity between the N-type layer 22 and the P-type layer 24 and, therefore, it is thought that the P-type layer 24 has greater resistance and a larger heat generation amount. Therefore, the generated heat in the P-type layer 24 must be released and, as described above, the heat can effectively be released to the insulated substrate 3 by increasing the electrode area of the positive electrode 25' jointed to the P-type layer 24.

Although the concave portion 14a is formed on the side of the wider electrode pattern 14 to face the projecting portion 15a from the narrower electrode pattern 15 across the predetermined gap B in the LED substrate 1 depicted in Fig. 15, if the area of the electrode pattern 14 can sufficiently be ensured, the concave portion 14a may not be formed. A projecting portion facing the projecting portion 15a from the electrode pattern 15 may be formed on the side of the electrode pattern 14 to enhance credibility in the reflow operation.

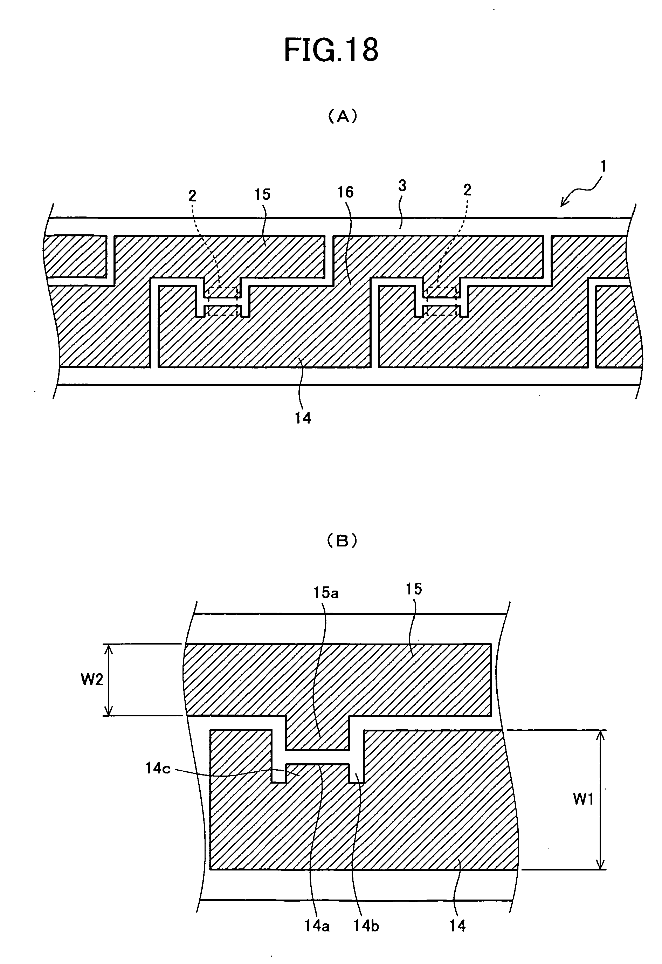

Fig. 18 is a diagram of a semiconductor light emitting element mounting substrate according to a yet further embodiment of the present invention, Fig. 18 (A) is a schematic of a portion of the semiconductor light emitting element mounting substrate, and Fig. 18(B) is an enlarged view of a portion of Fig. 18(A).

A cutout 14b is further formed on both longitudinal direction sides of the concave portion 14a formed in the wider electrode pattern 15 of a pair of the electrode patterns 14, 15. Therefore, the LED substrate 1 depicted in Fig. 18 is different from the LED substrate 1 depicted in Fig. 16 in that a projecting portion 14c is formed in the portion on which the positive electrode 25' of the LED chip 2 is placed. Therefore, the printed solder paste can rapidly be raised to high temperature in the projecting portion 14c of the electrode pattern 14 at the time of reflow as is the case with the projecting portion 15a of the electrode pattern 15, thereby enhancing the credibility of the reflow.

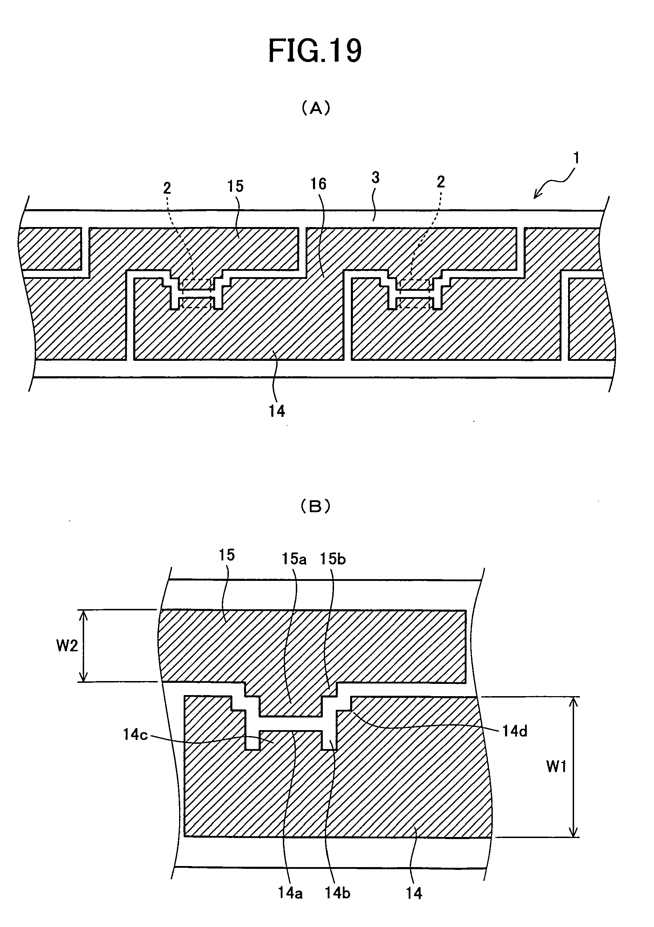

Fig. 19 is a diagram of a semiconductor light emitting element mounting substrate according to a still further embodiment of the present invention, Fig. 19 (A) is a schematic of a portion of the semiconductor light emitting element mounting substrate, and Fig. 19(B) is an enlarged view of a portion of Fig. 19(A).

The LED substrate 1 depicted in Fig. 19 is different from the LED substrate 1 depicted in Fig. 18 in that the projecting portion 15a formed on the narrower electrode pattern 15 of the pair of the electrode patterns 14, 15 is projected in a step-like manner to provide a step 15b. A recess 14d is disposed on the side of the electrode pattern 14 facing the step 15b.

Since the portion of the step 15b disposed on the projecting portion 15a of the electrode pattern 15 can be increased in width as compared to the top portion of the projecting portion 15a, the heat from the negative electrode 26 soldered to the projecting portion 15a of the electrode pattern 15 is more easily conducted via the wider step 15b and electrode pattern 15 to the insulated substrate 3. Although the stepped projecting portion has been described, any shapes may be available as long as the heat from the electrode is efficiently conducted via the electrode pattern to the insulated substrate. In other words, it is only necessary to form the projecting portion with the area increasing from the top portion of the projecting portion toward the electrode pattern side. For example, a trapezoidal shape having a narrow side as the top portion or a semicircular shape may be available.

Although the positive electrode and the negative electrode of the flip-chip LED chip 2 are soldered to the wider pattern electrode and the narrower electrode pattern, respectively, in one example of the embodiments of the present invention as described above, the electrode closer to the active layer may be soldered to the wider electrode pattern depending on a configuration of the electrode chip.

For example, instead of the LED chip depicted in Fig. 16, a chip configuration having the N-type layer 22 and the P-type layer 24 in reverse order may be available. In other words, in the case of the chip configuration having the P-type layer, the active layer, and the N-type layer in the order from the sapphire substrate, the negative electrode is disposed closer to the active layer than the positive layer. In this case, the electrode area of the negative electrode may be made greater than the electrode area of the positive electrode.

A semiconductor light emitting element mounted on the semiconductor light emitting element mounting substrate of the present invention may have a package configuration.

Fig. 20 is a diagram of a cross section of a semiconductor light emitting element having an LED package configuration. An LED package 70 is made up of an LED chip 71, a phosphor layer 72, a protection layer 73, a positive electrode 74a, a negative electrode 74b, vias 75, contact pads 75a, 75b, and a silicon sub-mount 76.

A method of manufacturing the LED package 70 will briefly be described. First, the silicon sub-mount 76 including at least one groove is formed by wet etching. The two vias 75 are disposed in a groove bottom portion of the silicon sub-mount 76. The contact pads 75a, 75b are disposed on the upper portions of the vias 75 and the positive electrode 74a and the negative electrode 74b are disposed on the lower portions. In the case of this example, the positive electrode 74a and the negative electrode 74b are respectively connected through the vias 75 to a P-type layer and an N-type layer of the LED chip 71.

The LED chip 71 is then mounted in the groove of the silicon sub-mount 76. The electrodes of the LED chip 71 are jointed and electrically connected to the contact pads 75a, 75b. The phosphor layer 72 is filled into the groove of the silicon sub-mount 76 to form an upper surface and the protection layer 73 is printed and formed on the upper surface.

In the case of the LED package depicted in Fig. 20, the positive electrode 74a and the negative electrode 74b are connected to the electrode patterns 14, 15 on the mount substrate of the LED package 70. As is the case with the LED chip depicted in Fig. 16, the electrode area of the positive electrode 74a (anode) is made larger than the electrode area of the negative electrode 74b (cathode). As a result, the generated heat of the LED package 7 can effectively be released to the substrate side as is the case with the LED chip depicted in Fig. 16.

Although the configuration of the semiconductor light emitting element mounted on the semiconductor light emitting element mounting substrate according to the present invention may be either the flip-chip LED chip 2 described above or the LED package 70 having the package configuration, the present invention is not limited to the flip-chip type and is applicable to a wire-bonding type chip configuration, for example.

Although the liquid-crystal display device has been described as the display device including the semiconductor light emitting element mounting substrate according to the present invention, such a liquid-crystal display device is applicable to various use applications, for example, a television receiver. In another form, the liquid-crystal display device is applied to a displaying portion of an information device such as a personal computer. In this case, the liquid-crystal display device may be connected through a cable such as DSUB (D-sub miniature) to the information device or may be integrally formed as the information device. In another case, the liquid-crystal display device may be used as an information display or a digital signage (electronic signage). In this case, the displaying portion may be used in a vertical position.

EXPLANATIONS OF REFERENCE NUMERALS

1...LED substrate; 2, 200...LED chip; 3...insulated substrate; 4, 5, 14, 15, 34, 35, 45, 44, 45, 54, 55...electrode pattern; 6, 16, 36, 46...wiring pattern; 15a...projecting portion; 21, 201...sapphire substrate; 22, 202...N-type layer; 23, 203...active layer; 24, 204...P-type layer; 25, 25' , 205...positive electrode; 26, 206...negative electrode; 60...model; 61...LED chip; 62...electrode pattern; 63...insulated substrate; 64...rear surface pattern; 65...backlight chassis; 66...air; 70, 300...LED package; 71, 301...LED chip; 72, 302...phosphor layer; 73, 303...protection layer; 74a...positive electrode; 74b...negative electrode; 75, 305...via; 75a, 75b, 305a, 305b...contact pad; 76, 306...silicon sub-mount; 100...television receiver; 102, 103...harnesses; 104...connector; 110...liquid-crystal display device; 111, 112...cabinet; 113...power source; 114...tuner; 115...stand; 120...liquid-crystal panel; 130...backlight apparatus; 140...bezel; 150...backlight chassis; 160...optical member; 161...diffusion plate; 162...optical sheet set; 170...frame; and 304...bottom electrode.

**Claims**

1. A semiconductor light emitting element mounting substrate for mounting a semiconductor light emitting element having a positive electrode and a negative electrode on the same plane, comprising: an insulated substrate; a pair of electrode patterns respectively connected to the positive electrode and the negative electrode on the insulated substrate; and a wiring pattern drawn out from each of the pair of the electrode patterns, wherein each of the pair of the electrode patterns has a larger area than the wiring pattern.

**2.** The semiconductor light emitting element mounting substrate as defined in claim 1, wherein the pair of the electrode patterns has facing portions facing each other in substantially parallel across a predetermined gap, and the positive electrode and the negative electrode of the semiconductor light emitting element are connected to the facing portions.

**3.** The semiconductor light emitting element mounting substrate as defined in claim 2, wherein the insulated substrate has a long strip shape, the pair of the electrode patterns extends in longitudinal direction on the insulated substrate and has different widths, and in the pair of the electrode pattern portions on which the positive electrode and the negative electrode of the semiconductor light emitting element are placed, at least one of the wider electrode pattern and the narrower electrode pattern has a projecting portion formed to project toward the other electrode pattern.

**4.** The semiconductor light emitting element mounting substrate as defined in any one of claims 1 to 3, wherein out of the positive electrode and the negative electrode of the semiconductor light emitting element, the electrode on the farther side from an active layer is connected to the narrower electrode pattern.

**5.** The semiconductor light emitting element mounting substrate as defined in claim 3 or 4, wherein a concave portion facing the projecting portion across a predetermined gap is formed on the side of the other electrode pattern.

**6.** The semiconductor light emitting element mounting substrate as defined in claim 5, wherein a gap between the projecting portion and the concave portion is positioned at substantially the center in the width direction of the pair of the electrode patterns.

**7.** The semiconductor light emitting element mounting substrate as defined in claim 5 or 6, wherein a cutout is formed on both longitudinal direction sides of the concave portion.

**8.** The semiconductor light emitting element mounting substrate as defined in any one of claims 3 to 7, wherein the projecting portion has a step-like shape.

**9.** The semiconductor light emitting element mounting substrate as defined in any one of claims 3 to 8, wherein the semiconductor light emitting element has the positive electrode and the negative electrode formed on the same surface side and has an electrode area of one electrode formed larger than an electrode area of the other electrode, and wherein the electrode with the larger electrode area is connected to the side of the wider electrode pattern.

**10.** The semiconductor light emitting element mounting substrate as defined in claim 9, wherein the electrode with a larger electrode area of the semiconductor light emitting element is closer to the active layer than the electrode with a smaller electrode area.

**11.** The semiconductor light emitting element mounting substrate as defined in claim 1 or 2, wherein the drawn-out directions of the wiring pattern drawn out from each of the pair of the electrode patterns are directions different from each other.

**12.** The semiconductor light emitting element mounting substrate as defined in any one of claims 1 to 3, wherein the insulated substrate has a long strip shape, and a gap of the pair of the electrode patterns is formed in parallel with longitudinal direction of the strip shape.

**13.** The semiconductor light emitting element mounting substrate as defined in any one of claims 1 to 12, wherein the insulated substrate has a long strip shape, and a plurality of the pairs of the electrode patterns is formed along the longitudinal direction of the strip shape to enable arrangement of a plurality of the semiconductor light emitting elements.

**14.** The semiconductor light emitting element mounting substrate as defined in any one of claims 1 to 13, wherein when W (w) is power of the semiconductor light emitting element, S ($m^2$) is an area of the pair of the electrode patterns, L (m) is a thickness of the insulated substrate, and p (W/ (m/K)) is a thermal conductivity of the insulated substrate, an average temperature difference $\Delta T$ between one surface and the other surface of the insulated substrate calculated by $\Delta T = W \cdot L / S / \rho$ is equal to or less than 12 degrees C.

**15.** A backlight chassis comprising the semiconductor light emitting element mounting substrate as defined in any one of claims 1 to 14.

**16.** A display device comprising the semiconductor light emitting element mounting substrate as defined in any one of claims 1 to 14.

**17.** A television receiver comprising the display device as defined in claim 16.

# FIG.1

100

111

110

112

114

113

115

EP 2 450 973 A1

# FIG.2

# FIG.3

EP 2 450 973 A1

# FIG.4

X

3

1

X

5

2

A

5

4

4

X

6

6

# FIG.5

2

21

5

22

23

26

24

25

4

A

3

# FIG.6

# FIG.7

——— HEAT CONDUCTION
—·—·— HEAT TRANSFER
———— HEAT RADIATION

# FIG.8

—◇— LED TEMPERATURE (DEGREES C)  —□— ELECTRODE PATTERN AVERAGE THERMAL FLOW RATE (W/m²)

# FIG.9

# FIG.10

# FIG.11

# FIG.12

# FIG.13

# FIG.14

EP 2 450 973 A1

# FIG.15

(A)

(B)

25

# FIG.16

# FIG.17

# FIG.18

（A）

（B）

# FIG.19

(A)

(B)

# FIG.20

# FIG.21

# FIG.22

# FIG.23

**INTERNATIONAL SEARCH REPORT**

| | International application No. |
|---|---|
| | PCT/JP2010/061317 |

A. CLASSIFICATION OF SUBJECT MATTER
*H01L33/62*(2010.01)i, *H01L33/64*(2010.01)i

According to International Patent Classification (IPC) or to both national classification and IPC

B. FIELDS SEARCHED

Minimum documentation searched (classification system followed by classification symbols)
H01L33/00-33/64

Documentation searched other than minimum documentation to the extent that such documents are included in the fields searched
Jitsuyo Shinan Koho          1922-1996     Jitsuyo Shinan Toroku Koho     1996-2010
Kokai Jitsuyo Shinan Koho    1971-2010     Toroku Jitsuyo Shinan Koho     1994-2010

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>Y | P 2007-129188 A (Hitachi Maxell, Ltd.),<br>24 May 2007 (24.05.2007),<br>paragraphs [0006], [0010], [0050]; fig. 1(b),<br>3(a)<br>& US 2007/0080438 A1    & KR 10-2007-0039398 A<br>& CN 1945822 A | 1,11,13-17<br>2,12 |
| Y | JP 2007-266590 A (Sony Corp.),<br>11 October 2007 (11.10.2007),<br>paragraph [0045]; fig. 9<br>(Family: none) | 2,12 |
| Y | JP 2006-134992 A (Hitachi Displays, Ltd.),<br>25 May 2006 (25.05.2006),<br>paragraph [0031]; fig. 3(a)<br>& US 2006/0092634 A1    & KR 10-2006-0052423 A<br>& CN 1783485 A          & TW 289366 B | 2,12 |

☒ Further documents are listed in the continuation of Box C.   ☐ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search<br>16 July, 2010 (16.07.10) | Date of mailing of the international search report<br>03 August, 2010 (03.08.10) |
|---|---|
| Name and mailing address of the ISA/<br>Japanese Patent Office | Authorized officer |
| Facsimile No. | Telephone No. |

Form PCT/ISA/210 (second sheet) (July 2009)

**INTERNATIONAL SEARCH REPORT**

International application No.

PCT/JP2010/061317

C (Continuation).   DOCUMENTS CONSIDERED TO BE RELEVANT

| Category* | Citation of document, with indication, where appropriate, of the relevant passages | Relevant to claim No. |
|---|---|---|
| A | JP 2008-124153 A  (Toyoda Gosei Co., Ltd.),<br>29 May 2008 (29.05.2008),<br>entire text; all drawings<br>(Family: none) | 1-17 |
| A | JP 2001-044498 A  (Nichia Chemical Industries, Ltd.),<br>16 February 2001 (16.02.2001),<br>entire text; all drawings<br>(Family: none) | 1-17 |
| A | JP 2007-294847 A  (Matsushita Electric Works, Ltd.),<br>08 November 2007 (08.11.2007),<br>entire text; all drawings<br>(Family: none) | 1-17 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2008034748 A
- JP 2005109254 A

- JP 2009111006 A